# EUROPEAN PATENT APPLICATION

(11) **EP 4 810 635 A1**
(43) Date of publication of application: **23.09.2026**
(21) Application number: 24896645.9
(22) Date of filing: 28.11.2024
(51) Int. Cl.: C22C 21/00, C22C 1/03, B22D 17/00

(54) **ALUMINUM ALLOY AND PREPARATION METHOD THEREFOR, DIE CASTING, WELDING ASSEMBLY, AND ELECTRONIC DEVICE**

(30) Priority: 30.11.2023 CN 202311626856
(71) Applicant: Huawei Technologies Co., Ltd., Shenzhen, Guangdong 518129 (CN); Dalian Yaming Auto Parts Co., Ltd., Dalian, Liaoning 116041 (CN)
(72) Inventor: JI, Dawei, Shenzhen, Guangdong 518129 (CN); LI, Chuanshan, Shenzhen, Guangdong 518129 (CN); CAI, Ming, Shenzhen, Guangdong 518129 (CN); WANG, Hua, Shenzhen, Guangdong 518129 (CN); SONG, Qinghe, Dalian, Liaoning 116041 (CN); FANG, Jianru, Dalian, Liaoning 116041 (CN); LU, Chao, Dalian, Liaoning 116041 (CN); ZHENG, Fuhui, Shenzhen, Guangdong 518129 (CN)
(74) Representative: Thun, Clemens
(86) International application number: PCT/CN2024/135250
(87) International publication number: WO 2025/113560

(57) **Abstract**

An aluminum alloy and a preparation method therefor, a die casting part, a welding component, and an electronic device are provided. Based on a total weight of the aluminum alloy, the aluminum alloy includes the following elements in weight percentage: 0.01% to 15% of La, 0.01% to 15% of Ce, 0.3% to 3% of Fe, 0.3% to 3.0% of Mn, and 0.01% to 0.5% of Zr, a sum of content of La and Ce is 3% to 15%, a remainder includes Al and inevitable impurities, and content of any impurity element in the inevitable impurities is less than or equal to 0.2%.

## Description

### CROSS-REFERENCE TO RELATED APPLICATIONS

This application claims priority to Chinese Patent Application No. 202311626856.5, filed with the China National Intellectual Property Administration on November 30, 2023 and entitled "ALUMINUM ALLOY AND PREPARATION METHOD THEREFOR, DIE CASTING PART, WELDING COMPONENT, AND ELECTRONIC DEVICE", which is incorporated herein by reference in its entirety.

### TECHNICAL FIELD

This application relates to the field of aluminum alloys, and specifically, to an aluminum alloy and a preparation method therefor, a die casting part, a welding component, and an electronic device.

### BACKGROUND

Brazing is a welding method in which a brazing metal, whose melting point is lower than that of a weldment, and the weldment are simultaneously heated to a melting temperature of the brazing metal, and a gap of a solid workpiece is filled with a liquid brazing metal to connect metals. Die casting aluminum alloys are widely used because of advantages of high production efficiency, low costs, and one-time molding of complex structures. However, a current die casting aluminum alloy mainly contains an element like Si. A melting point of an Al-Si aluminum alloy is low. For example, a melting point of an Al-Si alloy whose grade is ADC12 is 516°C, and a melting point of an Al-Si alloy whose grade is ADC10 is 538°C. However, a temperature of high-temperature brazing is generally about 600°C, which causes melting of the aluminum alloy in the brazing process. Although Al-1.6Mn can be brazed at a high temperature, serious material softening occurs in a high-temperature brazing process, and strength after being brazed is very low. Therefore, there is a lack of a die casting aluminum alloy that can still have high strength after being brazed at a high temperature.

### SUMMARY

This application provides an aluminum alloy and a preparation method therefor, a die casting part, a welding component, and an electronic device, to improve a melting point of the aluminum alloy and strength of the aluminum alloy after being brazed.

According to a first aspect, this application provides an aluminum alloy. Based on a total weight of the aluminum alloy, the aluminum alloy includes the following elements in weight percentage: 0.01% to 15% of La, 0.01% to 15% of Ce, 0.3% to 3% of Fe, 0.3% to 3.0% of Mn, and 0.01% to 0.5% of Zr, a sum of content of La and Ce is 3% to 15%, a remainder includes Al and inevitable impurities, and content of any impurity element in the inevitable impurities is less than 0.2%.

In the aluminum alloy in this application, La with a mass fraction of 0.01% to 15% and Ce with a mass fraction of 0.01% to 15% are added, to form, with Al, an aluminum-lanthanum-cerium rare-earth alloy with a high eutectic point, and the formed aluminum alloy has a high melting point. For example, the melting point of the aluminum alloy may be higher than 640°C. Fe may be added to form a long-strip second phase with Al, to improve yield strength of the aluminum alloy. The added iron can reduce an adhesion force of the aluminum alloy to a steel mold in a die casting molding process, reduce a mold sticking phenomenon, and improve a demolding effect of the aluminum alloy, so that a die casting molding effect is ensured. Mn may be added to further improve the demolding effect with Fe, improve a spheroidization rate of the second phase containing Fe, and improve a strengthening effect of the second phase of the aluminum alloy. Zr may be added to form a precipitated phase with Al, for example, Al₃Zr, which has a strengthening effect for the precipitated phase. Through a joint action of the foregoing elements, the obtained aluminum alloy may have a high melting point, so that melting of the aluminum alloy due to high-temperature brazing can be avoided. In addition, the aluminum alloy may also have high strength after being brazed at a high temperature.

In an optional implementation, in terms of weight percentage, a weight fraction of La in the aluminum alloy may be 2% to 10%, for example, 2% to 7%, or specifically, 2.4% to 4.0%. In an optional implementation, in terms of weight percentage, a weight fraction of Ce in the aluminum alloy may be 2% to 10%, for example, 5% to 8%, or 5.2% to 7.2%. In an optional implementation, the sum of the content of La and Ce is 8% to 11%, for example, 9% to 10.5%.

In an optional implementation, in terms of weight percentage, a weight fraction of Fe in the aluminum alloy may be 0.5% to 2.5%, for example, 1% to 1.5%, or 1.1% to 1.3%.

In an optional implementation, in terms of weight percentage, when the aluminum alloy does not contain Cr, a weight fraction of Mn may be 0.5% to 2%, for example, 0.6% to 1.5%, 0.6% to 1%, or 0.85% to 1%.

In an optional implementation, in terms of weight percentage, a weight fraction of Zr in the aluminum alloy may be 0.1% to 0.5%, for example, 0.15% to 0.40%, 0.20% to 0.35%, or 0.20% to 0.30%.

In an optional implementation, in terms of weight percentage, content of the elements La, Ce, Fe, Mn, and Zr in the aluminum alloy is as follows: 2% to 7% of La, 5% to 8% of Ce, 1.0% to 1.5% of Fe, 0.6% to 1% of Mn, and 0.2% to 0.5% of Zr. In an optional implementation, in terms of weight percentage, the content of the elements La, Ce, Fe, Mn, and Zr in the aluminum alloy is as follows: 2% to 5% of La, 5% to 7.5% of Ce, 1.1% to 1.3% of Fe, 0.8% to 1% of Mn, and 0.2% to 0.3% of Zr. The aluminum alloy with such compositions may have a higher melting point and higher yield strength after being brazed at a high temperature.

In an optional implementation, in terms of weight percentage, the aluminum alloy further includes 0.01% to 0.5% of Cr, for example, 0.15% to 0.5%, 0.15% to 0.4%, or 0.15% to 0.25%. Cr is added to form a reinforcing phase of the second phase containing Cr and refine grains, to improve strength of the aluminum alloy. In an optional implementation, in terms of weight percentage, when the aluminum alloy contains Cr, a weight fraction of Mn may be 0.5% to 1.2%, for example, 0.5% to 0.9%, or 0.5% to 0.6%.

In an optional implementation, in terms of weight percentage, content of the elements La, Ce, Fe, Mn, Zr, and Cr in the aluminum alloy is as follows: 2% to 7% of La, 5% to 8% of Ce, 1.0% to 1.5% of Fe, 0.45% to 0.60% of Mn, 0.2% to 0.5% of Zr, and 0.1% to 0.4% of Cr. In an optional implementation, in terms of weight percentage, the content of the elements La, Ce, Fe, Mn, Zr, and Cr in the aluminum alloy is as follows: 2% to 5% of La, 5% to 7.5% of Ce, 1.1% to 1.3% of Fe, 0.5% to 0.6% of Mn, 0.2% to 0.35% of Zr, and 0.2% to 0.3% of Cr. The aluminum alloy with such compositions may have a higher melting point and higher yield strength after being brazed at a high temperature.

In an optional implementation, in terms of weight percentage, the aluminum alloy further includes at least one of the following elements: 0.01% to 0.5% of Sc, 0.01% to 0.5% of V, 0.01% to 0.5% of Mo, 0.01% to 0.5% of Ti, and 0.01% to 0.5% of Mg. The foregoing elements are added to help improve thermal conductivity and hardness of the aluminum alloy.

In an optional implementation, a melting point of the aluminum alloy is greater than or equal to 620°C. In an optional implementation, a thermal conductivity coefficient of the aluminum alloy is greater than or equal to 120 W/m·K. In an optional implementation, yield strength of the aluminum alloy after being brazed at 590°C to 630°C is greater than or equal to 80 MPa.

According to a second aspect, this application provides an aluminum alloy preparation method. The preparation method includes: melting, based on compositions of the aluminum alloy in this application, intermediate alloys of various elements to obtain an alloy melt, and performing die casting molding on the alloy melt after refining, degassing, and drossing, to obtain the aluminum alloy.

According to a third aspect, this application provides a die casting part prepared by using the aluminum alloy in this application.

According to a fourth aspect, this application provides a welding component, including a metallic matrix and the die casting part in this application, where the die casting part is connected to the metallic matrix through brazing.

According to a fifth aspect, this application provides an electronic device, including a processing unit and a package part configured to package the processing unit, where at least a part of structural parts in the package part are the die casting part in this application.

For technical effect that can be achieved in the second aspect to the fifth aspect, refer to corresponding effect descriptions in the first aspect. Details are not described herein again.

For data in the foregoing possible implementations of this application, for example, data such as weight percentages of La, Ce, Fe, Mn, and Zr, during measurement, values within an engineering measurement error range should be understood as falling within a range limited in this application.

### BRIEF DESCRIPTION OF DRAWINGS

FIG. 1A to FIG. 1C are a diagram of a structure of a heat dissipation panel;
FIG. 2A and FIG. 2B are a diagram of a microstructure of an aluminum alloy according to an embodiment;
FIG. 3 is an ultrasonic detection diagram of a welding surface of a die casting part after being brazed;
FIG. 4 is a diagram of a DSC test curve of an aluminum alloy according to Embodiment 1;
FIG. 5 is a stress and strain curve of an aluminum alloy according to Embodiment 1 after being brazed;
FIG. 6 is a diagram of a welding joint after an aluminum alloy according to Embodiment 1 is brazed with another part;
FIG. 7 is a stress and strain curve at a welding joint of an aluminum alloy according to Embodiment 1; and
FIG. 8A and FIG. 8B are a diagram of a pressure-resistance blasting object after a die casting structural part and a plate are brazed according to an embodiment.

### DESCRIPTION OF EMBODIMENTS

To make objectives, technical solutions, and advantages of this application clearer, the following further describes this application in detail with reference to accompanying drawings.

Terms used in the following embodiments are merely intended to describe specific embodiments, but are not intended to limit this application. The terms "one", "a", "the", "the foregoing", "the", and "the one" of singular forms used in the specification and the appended claims of this application are also intended to include expressions such as "one or more", unless otherwise specified in the context clearly. Reference to "an embodiment", "some embodiments", or the like described in the specification indicates that one or more embodiments of this application include a specific feature, structure, or characteristic described with reference to embodiments. The terms "include", "comprise", "have", and their variants all mean "include but are not limited to", unless otherwise specifically emphasized. In this application, unless otherwise specified, a percentage (%) or a part refers to a weight percentage or a weight part relative to a composition. In this application, unless otherwise specified, involved compositions or preferred compositions thereof may be combined to form a new technical solution. In this application, unless otherwise specified, a value range "a to b" represents an abbreviated representation of any real number combination between a and b, where both a and b are real numbers.

Aluminum alloys are widely used in communication devices, automobiles, consumer electronics, and the like because of advantages of high production efficiency, low costs, and molding of complex structures. For example, aluminum alloys may be widely used in boxes of various electronic devices. The electronic device is, for example, but is not limited to, a communication device like a large-scale multiple-input multiple-output system, a remote radio unit, or an active antenna unit. Certainly, in addition to the communication device, the electronic device may further include devices such as an electronic computer, a numerical control device, a program control device, an in-vehicle thermal cycle box, and a head unit heat dissipation box. Examples are not enumerated herein.

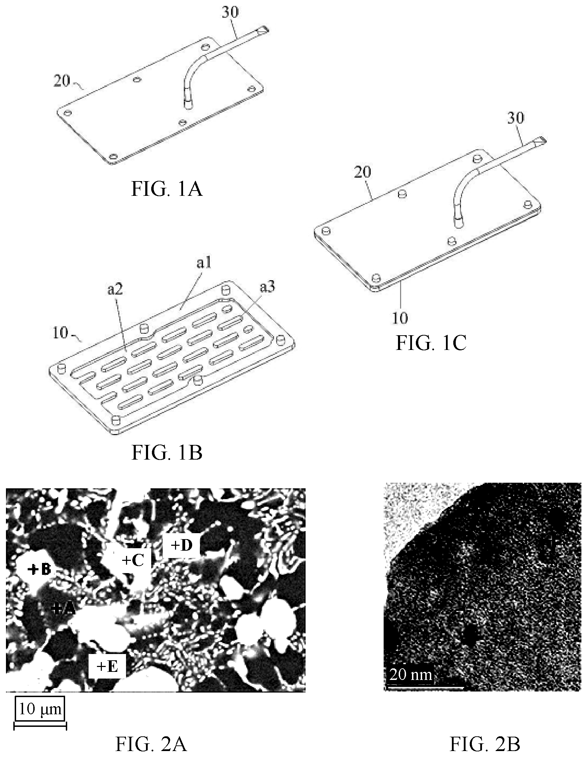

For example, the electronic device may include a box and a processing unit located in the box. The processing unit may be any unit that has a processing function in the electronic device, for example, a processor or a processing circuit. A component of the box may include a heat dissipation panel. The processing unit may be disposed on the heat dissipation panel, and the heat dissipation panel is used to cool the processing unit. FIG. 1A to FIG. 1C are a diagram of a structure of a heat dissipation panel. The heat dissipation panel may be used as a part of a box of an electronic device. With reference to FIG. 1A to FIG. 1C, the heat dissipation panel may include a substrate and a cover. A structure of the cover is shown in FIG. 1A, and a structure of the substrate is shown in FIG. 1B. A structure obtained by connecting the substrate and the cover through sealing is shown in FIG. 1C. A coolant flow channel is disposed in the substrate to implement flow of the coolant. The cover is connected to the substrate through sealing, to implement sealing of the coolant flow channel. The sealed connection between the substrate and the cover can be implemented through brazed sealing. The substrate 10 has a frame a1, a bottom plate a2, and an island structure a3 disposed on the bottom plate a2, a part of the island structure a3 is connected to the frame a1, and the island structure a3 is disposed in space enclosed by the frame a1 and the bottom plate a2. The substrate may be prepared by using a die casting aluminum alloy through a die casting process, to save materials and reduce machining processes. The cover 20 is a brazing metal composite plate (as shown in the figure (a)), and the cover 20 is a flat plate structure with a specific thickness. When the substrate is welded to the cover, a brazing metal may be placed on a surface of the cover 20. The surface of the cover 20 with the brazing metal is in contact with the substrate 10, and the brazing metal on the surface of the cover 20 is in contact with the frame a1 and the island structure a3 of the substrate 10. After being brazed at a high temperature, the cover 20 and the substrate 20 may be welded together through the island structure a3 and the frame a1. An area between the cover 20 and the substrate 20 other than the island structure a3 forms a cavity, and is used as the coolant flow channel. When the heat dissipation panel is used to dissipate heat, a liquid injection pipe 30 disposed on the cover 20 may be used to inject refrigerant into two coolant flow channels, so that the refrigerant can evaporate, cool, and circularly flow in the cavity, to take away heat and implement a heat dissipation function. Certainly, the cover 20 is not limited to a flat plate structure, and may alternatively be another structure that can be connected to the substrate through sealing and form space between the cover and the substrate. It should be understood that a structure of the die casting part in this application is not limited to that shown in FIG. 1A to FIG. 1C, and may be another shape that is set based on factors such as an actual application scenario and a use purpose. This is not limited herein.

When an aluminum alloy die casting part is welded, a high-temperature brazing manner may be used for welding. In this case, it needs to be ensured that a melting point of the aluminum alloy die casting part is higher than a temperature used during high-temperature brazing. If the melting point of the aluminum alloy casting part is lower than the temperature used during high-temperature brazing, the aluminum alloy die casting part is melted during high-temperature brazing, and a desired structure cannot be obtained. Generally, the temperature used during high-temperature brazing is about 600°C. A commonly used aluminum alloy die casting part is generally an Al-Si alloy, and a melting point of the Al-Si alloy is low, which is about 577°C. It is clear that the melting point of the Al-Si alloy is lower than the temperature used during high-temperature brazing. Therefore, an aluminum alloy casting part prepared by using the Al-Si alloy cannot be used in the high-temperature brazing field.

In view of this, an embodiment of this application provides an aluminum alloy. The aluminum alloy may be used to form various complex die casting parts through a die casting process. The aluminum alloy may have a high melting point. For example, the melting point may reach 640°C or higher. The die casting part formed by using the aluminum alloy in this embodiment of this application may not be melted after being brazed at a high temperature, and may further have high yield strength after being brazed at a high temperature. For example, the yield strength may be higher than 120 MPa, and requirements for high structural strength and high reliability are met. In addition, the aluminum alloy in this embodiment of this application does not react with a brazing metal, so that an appearance and mechanical properties of the aluminum alloy are not affected.

The aluminum alloy in this embodiment of this application includes Al, alloy elements, and inevitable impurities. Based on a total weight of the aluminum alloy, the alloy elements may include the following elements in weight percentage: 0.01% to 15% of La, 0.01% to 15% of Ce, 0.3% to 3% of Fe, 0.3% to 3.0% of Mn, and 0.01% to 0.5% of Zr, and a sum of content of La and Ce is 3% to 15%. When Si exists in a form of an inevitable impurity, content of Si is less than or equal to 0.2%, or preferably, less than or equal to 0.1%. In addition, in the aluminum alloy in this embodiment of this application, content of any impurity element in the inevitable impurities is less than 0.2%. Total content of the inevitable impurities is less than or equal to 0.4%.

### Lanthanum La and cerium Ce

For added lanthanum and cerium: An aluminum-lanthanum alloy whose eutectic point temperature is higher than 640°C may be formed by adding lanthanum with a mass fraction of 0.01% to 15%, and an aluminum-cerium alloy whose eutectic point temperature is higher than 640°C may be formed by adding cerium with a mass fraction of 0.01% to 15%, so that the aluminum alloy added with lanthanum and cerium has a high melting point, and the melting point of the aluminum alloy may be higher than 630°C. When a temperature of high-temperature brazing is about 600°C, the melting point of the aluminum alloy is higher than the temperature of high-temperature brazing, so that no melting phenomenon occurs during high-temperature brazing of the aluminum alloy, and the aluminum alloy is applicable to high-temperature brazing. In addition, a standard electrode potential of lanthanum is about - 2.379 V, a standard electrode potential of cerium is about -2.336 V, and a standard electrode potential of aluminum is about -1.66 V. It is clear that an electron loss capability of either lanthanum or cerium is stronger than that of aluminum. Therefore, when corrosion occurs, lanthanum and cerium are corroded first, and aluminum is difficult to be corroded. In this way, lanthanum and cerium are introduced to protect aluminum, and corrosion resistance of the aluminum alloy is improved. In addition, in a melt solidification and cooling stage of die casting molding, intermetallic compound second-phase particles, for example, Al₁₁(La, Ce)₃, may be formed by introducing lanthanum and cerium to aluminum. The intermetallic compound second-phase particles may be referred to as autogenetic second-phase particles. These intermetallic compound second-phase particles may be used as heterogenous nuclei, to increase a number of nuclei in the aluminum alloy. In a process of nucleus growth, various nuclei collide with each other and inhibit grain growth, and refine grains. Because the intermetallic compound second-phase particles are generated only in the melt solidification and cooling stage of die casting molding, before the melt solidification and cooling stage of die casting molding, the heterogenous nucleus cannot refine grains because there is no such intermetallic compound second-phase particles. Therefore, lanthanum and cerium are added to improve mechanical properties of the aluminum alloy after die casting molding to some extent, but the improvement is limited.

In this embodiment of this application, when the content of La is controlled to be 0.01% to 15%, or specifically, 2% to 10%, 2% to 7%, or 2.4% to 4.0%, an effect of increasing the melting point of the aluminum alloy is more obvious. In terms of weight percentage, an addition amount of La in the aluminum alloy may be, for example, 0.01%, 0.5%, 1%, 1.5%, 2%, 2.2%, 2.5%, 2.8%, 3%, 3.2%, 3.5%, 3.8%, 4%, 4.2%, 4.5%, 4.8%, 5%, 5.2%, 5.5%, 5.8%, 6%, 6.2%, 6.5%, 6.8%, 7%, 7.2%, 7.5%, 7.8%, 8%, 8.5%, 9%, 10%, 11%, 12%, 13%, 15%, or any value between the foregoing two values. The foregoing listed values are examples for description. A lower limit value of the addition amount of La may be any one of the foregoing values, or may be a value between the foregoing two values, and a lower limit value of the addition amount of La may be any one of the foregoing values, or may be a value between the foregoing two values.

In this embodiment of this application, when the content of La is controlled to be 0.01% to 15%, or specifically, 2% to 10%, 5% to 8%, or 5.2% to 8%, an effect of increasing the melting point of the aluminum alloy is more obvious. In terms of weight percentage, an addition amount of Ce in the aluminum alloy may be, for example, 0.5%, 1%, 1.5%, 2%, 2.2%, 2.5%, 2.8%, 3%, 3.2%, 3.5%, 3.8%, 4%, 4.2%, 4.5%, 4.8%, 5%, 5.2%, 5.5%, 5.8%, 6%, 6.2%, 6.5%, 6.8%, 7%, 7.2%, 7.5%, 7.8%, 8%, 8.5%, 9%, 10%, 11%, 12%, 13%, 15%, or any value between the foregoing two values. The foregoing listed values are examples for description. A lower limit value of the addition amount of Ce may be any one of the foregoing values, or may be a value between the foregoing two values, and a lower limit value of the addition amount of Ce may be any one of the foregoing values, or may be a value between the foregoing two values.

In terms of weight percentage, a total addition amount of La and Ce in the aluminum alloy may be 3% to 15%, for example, 8% to 11%, or 9% to 10.5%. For example, the total addition amount may be, for example, 8%, 8.2%, 8.5%, 8.7%, 9%, 9.2%, 9.5%, 9.7%, 10%, 10.2%, 10.5%, 10.7%, 11%, 12%, 13%, 15%, or any value between the foregoing two values. The foregoing listed values are examples for description. A lower limit value of the addition amount of La and Ce may be any one of the foregoing values, or may be a value between the foregoing two values, and a lower limit value of the addition amount of La and Ce may be any one of the foregoing values, or may be a value between the foregoing two values.

### Iron Fe:

For Fe: Iron with a mass fraction of 0.3% to 3% is added. In a melt solidification and cooling stage of die casting molding, intermetallic compound second-phase particles, for example, (La, Ce)Fe₂Al₁₀, may also be formed by adding iron in molten aluminum. The intermetallic compound second-phase particles may also be referred to as autogenetic second-phase particles. In a die casting molding process of the aluminum alloy, these intermetallic compound second-phase particles may also be used as heterogenous nuclei to refine grains. Similarly, because these intermetallic compound second-phase particles are generated in the melt solidification and cooling stage of die casting molding, mechanical properties of the aluminum alloy can also be improved to some extent, but the improvement is limited. In addition, the added iron can reduce an adhesion force of the aluminum alloy to a steel mold in the die casting molding process, reduce a mold sticking phenomenon, and improve a demolding effect of the aluminum alloy, so that a die casting molding effect is improved.

When the content of Fe is 0.3% to 3%, or specifically, 0.5% to 2.5%, 1% to 1.5%, or 1.1% to 1.3%, an effect of increasing the yield strength of the aluminum alloy is more obvious. In terms of weight percentage, an addition amount of Fe in the aluminum alloy may be, for example, 0.3%, 0.4%, 0.5%, 0.6%, 0.7%, 0.8%, 0.9%, 1.0%, 1.1%, 1.2%, 1.3%, 1.4%, 1.5%, 1.6%, 1.7%, 1.8%, 1.9%, 2.0%, 2.1%, 2.2%, 2.3%, 2.4%, 2.5%, 2.6%, 2.7%, 2.8%, 2.9%, 3%, or any value between the foregoing two values. The foregoing listed values are examples for description. A lower limit value of the addition amount of Fe may be any one of the foregoing values, or may be a value between the foregoing two values, and a lower limit value of the addition amount of Fe may be any one of the foregoing values, or may be a value between the foregoing two values.

### Manganese Mn:

For added manganese: Manganese with a mass fraction of 0.3% to 3% is added to implement solid solution strengthening. In addition, manganese may convert the sheet-like intermetallic compound second-phase particles containing iron into fine spherical intermetallic compound second-phase particles, to improve a strengthening effect of the intermetallic compound second-phase particles containing iron, and improve an enhancement effect of iron on the mechanical properties of the aluminum alloy under the action of manganese. In addition, because a eutectic point temperature of aluminum manganese is about 658°C, and a solidification point temperature of aluminum is about 660°C, addition of manganese has little impact on the melting point of the aluminum alloy. In addition, combination of manganese and iron can further reduce mold sticking tendency of a casting part to a steel mold, to improve a die casting molding effect.

Content of Mn may be 0.3% to 1.2%. When the alloy elements of the aluminum alloy do not contain Cr, and when the content of Mn is within a range of 0.7% to 1.1%, 0.7% to 1%, or 0.85% to 1%, an effect of increasing the yield strength of the aluminum alloy is more obvious. In terms of weight percentage, an addition amount of Mn in the aluminum alloy may be, for example, 0.3%, 0.35%, 0.4%, 0.45%, 0.5%, 0.55%, 0.6%, 0.65%, 0.7%, 0.75%, 0.8%, 0.85%, 0.9%, 0.95%, 1.0%, 1.05%, 1.1%, 1.15%, 1.2%, or any value between the foregoing two values. The foregoing listed values are examples for description. A lower limit value of the addition amount of Mn may be any one of the foregoing values, or may be a value between the foregoing two values, and a lower limit value of the addition amount of Mn may be any one of the foregoing values, or may be a value between the foregoing two values.

### Zirconium Zr:

For added zirconium: Zirconium with a mass fraction of 0.01% to 0.5% is added. Zirconium, as a heterogenous nucleus, can promote forming of a large quantity of nano-precipitated phases, for example, Al₃Zr. In the die casting molding process of the aluminum alloy, zirconium refines grains, to further improve mechanical properties of the aluminum alloy through die casting molding and high-temperature brazing. When content of Zr is too low, goals of effectively refining grains and improving the strength of aluminum alloy cannot be achieved. When content of Zr is too high, the strength is not significantly improved, and costs are increased.

When the content of Zr may be 0.01% to 0.5%, for example, 0.1% to 0.5%, or specifically, 0.15% to 0.5%, 0.2% to 0.4%, or 0.2% to 0.35%, an effect of increasing the yield strength of the aluminum alloy is more obvious. In terms of weight percentage, an addition amount of Zr in the aluminum alloy may be, for example, 0.01%, 0.02%, 0.03%, 0.05%, 0.07%, 0.08%, 0.1%, 0.12%, 0.15%, 0.18%, 0.2%, 0.22%, 0.25%, 0.28%, 0.3%, 0.33%, 0.35%, 0.38%, 0.4%, 0.42%, 0.45%, 0.5%, or any value between the foregoing two values. The foregoing listed values are examples for description. A lower limit value of the addition amount of Zr may be any one of the foregoing values, or may be a value between the foregoing two values, and a lower limit value of the addition amount of Zr may be any one of the foregoing values, or may be a value between the foregoing two values.

In conclusion, when specific content of lanthanum, cerium, iron, manganese, and zirconium are added to aluminum, the melting point is improved and mechanical reinforcement is implemented, so that the obtained aluminum alloy has a high melting point, can be used for high-temperature brazing, and has good mechanical properties, corrosion resistance, and die casting molding effect.

In the aluminum alloy in some embodiments, based on the total mass of the aluminum alloy, the aluminum alloy includes the following elements in weight percentage: 2% to 7% of La, 5% to 8% of Ce, 1.0% to 1.5% of Fe, 0.7% to 1% of Mn, and 0.2% to 0.5% of Zr. A sum of content of La and Ce is 5% to 15%, for example, 8% to 11%. The aluminum alloy does not include Si, or Si exists in a form of an inevitable impurity. A remainder includes Al and inevitable impurities. Content of any impurity element in the inevitable impurities is less than 0.2%. When Si exists in the form of an inevitable impurity, content of Si is less than 0.2%, for example, less than or equal to 0.1%.

### Chromium Cr:

In the aluminum alloy in some embodiments, alloy compositions may further include Cr. In terms of weight percentage, content of Cr may be, for example, 0.01% to 0.5%. Cr may be added to form an AlCeCrMn phase with Al, Ce, and Mn, and the intermetallic compound is converted into a dense second-phase particle with a higher spheroidization rate, to refine grains, reduce an internal defect, improve a strengthening effect, and further improve strength of the aluminum alloy. When the content of Cr may be 0.15% to 0.5%, or specifically, 0.15% to 0.4%, or 0.2% to 0.4%, an effect of increasing the yield strength of the aluminum alloy is more obvious. In terms of weight percentage, an addition amount of Cr in the aluminum alloy may be, for example, 0.01%, 0.02%, 0.05%, 0.07%, 0.1%, 0.12%, 0.15%, 0.18%, 0.2%, 0.22%, 0.25%, 0.28%, 0.3%, 0.32%, 0.35%, 0.37%, 0.4%, 0.42%, 0.45%, 0.48%, 0.5%, or any value between the foregoing two values. The foregoing listed values are examples for description. A lower limit value of the addition amount of Cr may be any one of the foregoing values, or may be a value between the foregoing two values, and a lower limit value of the addition amount of Cr may be any one of the foregoing values, or may be a value between the foregoing two values.

When the aluminum alloy contains Cr, an addition amount of Mn in the aluminum alloy may be 0.3% to 0.7%, 0.4% to 0.7%, 0.45% to 0.7%, or 0.45% to 0.60%, so that the yield strength of the aluminum alloy may be further increased.

In the aluminum alloy in some embodiments, based on the total mass of the aluminum alloy, the aluminum alloy includes the following elements in weight percentage: 2% to 7% of La, 5% to 8% of Ce, 1.0% to 1.5% of Fe, 0.45% to 0.6% of Mn, 0.2% to 0.5% of Zr, and 0.1% to 0.4% of Cr. A sum of content of La and Ce is 5% to 15%, for example, 8% to 11%. The aluminum alloy does not include Si, or Si exists in a form of an inevitable impurity. A remainder includes Al and inevitable impurities. Content of any impurity element in the inevitable impurities is less than 0.2%. When Mg exists in the form of an inevitable impurity, content of Mg is less than or equal to 0.2%.

FIG. 2A and FIG. 2B are a diagram of a microstructure of an aluminum alloy according to an embodiment. As shown in FIG. 2A and FIG. 2B, in the microstructure of the aluminum alloy in this embodiment of this application, phases are evenly distributed and sizes are small, and a shape of a grain is close to a spherical equiaxial structure. Therefore, it can be noted that, in the aluminum alloy in this application, a large quantity of second phases are evenly embedded on an aluminum matrix. After the aluminum alloy is brazed at a high temperature, the large quantity of second phases can effectively suppress grain growth and strengthen the aluminum alloy.

In a crystalline phase structure shown in FIG. 2A and FIG. 2B, shape descriptions of grains of different phases and compositions of the phases are listed in Table 1.

**Table 1**

| Sequence number | Phase | Phase composition | Phase shape |
|---|---|---|---|
| A | α-Al | 100Al | Spherical matrix |
| B | Al(La, Ce)FeMn | 57Al-19Ce-7La-11Fe-6Mn | Block |
| C | AlCeCrMn | 73Al-15Ce-10Cr-2Mn | Block or sheet |
| D | Al₃(La, Ce) + α-Al | 85Al-9.5Ce-5.5La | Mesh |
| E | Al₃(La, Ce) | Al₃(La, Ce) | dot and evenly distributed |
| F | AlZr | Al₃Zr | Nano-spherical |

With reference to FIG. 2A and FIG. 2B and Table 1, it can be learned that elements interact with each other to form phase structures of different shapes. Al₃(La, Ce) is evenly distributed in a dot shape, and Al₃(La, Ce) + α-Al is distributed between grains of a spherical α-Al matrix in a network structure. Second-phase Al(La, Ce)FeMn and AlCeCrMn are evenly distributed in a block shape, to help improve strength of the aluminum alloy. In addition, Zr exists in a form of the precipitated phase of Al₃Zr, has a nano-spherical structure, can refine grains of each phase, and improve the material strength by blocking dislocation movement by the precipitated phase. The foregoing elements are used to form different second-phase/precipitated-phase fine grains and prevent grain growth, so that the material after being brazed has high strength.

The melting point of the aluminum alloy containing the foregoing compositions may be greater than or equal to 600°C, for example, greater than or equal to 630°C. In addition, the thermal conductivity coefficient of the aluminum alloy containing the foregoing compositions may be greater than or equal to 120 W/m·K. In addition, yield strength of the aluminum alloy in this embodiment of this application after being brazed at 590°C to 630°C is greater than or equal to 100 MPa, for example, greater than or equal to 120 MPa. The aluminum alloy in this embodiment of this application may succeed in a 720-hour neutral salt spray test. After the die casting part is brazed, a height of a bubble on the surface of the die casting part is less than or equal to 0.5 mm, for example, less than or equal to 0.2 mm. For another example, there may be no bubble on the surface of the die casting part. A brazed rate is greater than or equal to 60%, for example, greater than or equal to 70%, or greater than or equal to 90%. Therefore, in the brazing process, phenomena of pseudo soldering and solder empty are reduced.

In addition to the foregoing element compositions, in terms of weight percentage, the aluminum alloy in this embodiment of this application may further include at least one of the following elements: 0.01% to 0.5% of V, 0.01% to 0.5% of Mo, 0.01% to 0.5% of Ti, 0.01% to 0.5% of Sc, and 0.01 to 0.5% of Mg. For example, in some embodiments, the aluminum alloy may include V of a weight percentage of 0.01% to 0.5%. In some embodiments, the aluminum alloy may include Mo of a weight percentage of 0.01% to 0.5%. In some embodiments, the aluminum alloy may include Ti of a weight percentage of 0.01% to 0.5%. In some embodiments, the aluminum alloy may include Sc of a weight percentage of 0.01% to 0.5%. In some embodiments, the aluminum alloy may include Mg of a weight percentage of 0.01% to 0.5%. V, Mo, Ti, and Mg may have an effect similar to Cr and Zr in the aluminum alloy. Sc may further strengthen the aluminum alloy, to further improve mechanical properties and corrosion resistance of the aluminum alloy. Therefore, addition of the foregoing elements can help further improve properties such as the melting point, the yield strength, the thermal conductivity, and the hardness of the aluminum alloy.

An addition amount of V may be, for example, 0.01%, 0.05%, 0.1%, 0.15%, 0.2%, 0.25%, 0.3%, 0.35%, 0.4%, 0.45%, 0.5%, or any value between the foregoing two values. The foregoing listed values are examples for description. A lower limit value of the addition amount of V may be any one of the foregoing values, or may be a value between the foregoing two values, and a lower limit value of the addition amount of V may be any one of the foregoing values, or may be a value between the foregoing two values. An addition amount of Mo may be, for example, 0.01%, 0.05%, 0.1%, 0.15%, 0.2%, 0.25%, 0.3%, 0.35%, 0.4%, 0.45%, 0.5%, or any value between the foregoing two values. The foregoing listed values are examples for description. A lower limit value of the addition amount of Mo may be any one of the foregoing values, or may be a value between the foregoing two values, and a lower limit value of the addition amount of Mo may be any one of the foregoing values, or may be a value between the foregoing two values. An addition amount of Ti may be, for example, 0.01%, 0.05%, 0.1%, 0.15%, 0.2%, 0.25%, 0.3%, 0.35%, 0.4%, 0.45%, 0.5%, or any value between the foregoing two values. The foregoing listed values are examples for description. A lower limit value of the addition amount of Ti may be any one of the foregoing values, or may be a value between the foregoing two values, and a lower limit value of the addition amount of Ti may be any one of the foregoing values, or may be a value between the foregoing two values. An addition amount of Sc may be, for example, 0.01%, 0.05%, 0.1%, 0.15%, 0.2%, 0.25%, 0.3%, 0.35%, 0.4%, 0.45%, 0.5%, or any value between the foregoing two values. The foregoing listed values are examples for description. A lower limit value of the addition amount of Sc may be any one of the foregoing values, or may be a value between the foregoing two values, and a lower limit value of the addition amount of Sc may be any one of the foregoing values, or may be a value between the foregoing two values. An addition amount of Mg may be, for example, 0.01%, 0.05%, 0.1%, 0.15%, 0.2%, 0.25%, 0.3%, 0.35%, 0.4%, 0.45%, 0.5%, or any value between the foregoing two values. The foregoing listed values are examples for description. A lower limit value of the addition amount of Mg may be any one of the foregoing values, or may be a value between the foregoing two values, and a lower limit value of the addition amount of Mg may be any one of the foregoing values, or may be a value between the foregoing two values.

It should be noted that a main composition of the aluminum alloy in this embodiment of this application is aluminum, and a sum of mass percentages of the compositions is 100% in terms of mass percentage. In this embodiment of this application, inevitable impurities may be introduced by a raw material of each composition, or may be introduced by a production device or a tool in a processing and preparation process. For example, the inevitable impurities may include Si, Cu, Ni, Zn, Ti, Pb, Sn, and another impurity. Content of each inevitable impurity may be less than or equal to 0.20%. For example, in terms of weight percentage, content of Si is less than or equal to 0.2%, for example, less than or equal to 0.12%; content of Cu is 0.2%, for example, less than or equal to 0.15%; content of Mg is 0.2%, for example, less than or equal to 0.05%; content of Ni is 0.2%, for example, less than or equal to 0.05%; content of Zn is 0.2%, for example, less than or equal to 0.10%; content of Ti is 0.2%, for example, less than or equal to 0.15%; content of Pb is 0.2%, for example, less than or equal to 0.02%; content of Sn is 0.2%, for example, less than or equal to 0.02%; and total content of other impurities is 0.4%, for example, less than or equal to 0.3%. To avoid affecting final performance of the aluminum alloy, the content of the inevitable impurities may be controlled to be less than 0.4%, or may be further controlled to be less than 0.3%. For example, the content of the finally introduced impurities may be controlled by controlling purity of the raw material and cleanliness of the device in the preparation process.

The compositions of the aluminum alloy are explained and described above. The following further describes an aluminum alloy preparation method.

The aluminum alloy preparation method in this embodiment of this application may include the following steps: Based on compositions of the aluminum alloy in this application, aluminum and intermediate alloys containing various elements are melted, to obtain an alloy melt, and die casting molding is performed on the alloy melt after refining, degassing, and drossing, to obtain the aluminum alloy. In this way, an aluminum alloy casting part with specific compositions can be manufactured, and the prepared aluminum alloy casting part has a high melting point, can be used for high-temperature brazing, and has good mechanical properties, corrosion resistance, and die casting molding effect.

The molten aluminum may be obtained by heating and melting a pure aluminum ingot. The pure aluminum ingot may be a recycled aluminum raw material. Another element may be added in a form of an intermediate alloy, to reduce production costs. For example, an intermediate alloy of La and Ce may be, for example, an Al-(La, Ce) mixed rare-earth intermediate alloy. For example, in the Al-(La, Ce) mixed rare-earth intermediate alloy, a mass ratio of La to Ce may be 30:70 to 50:50, for example, 30:70, 35:65, 40:60, and 50:50. An intermediate alloy of Fe may be an Al-Fe intermediate alloy. An intermediate alloy of Mn may be an Al-Mn intermediate alloy. An intermediate alloy of Zr may be an Al-Zr intermediate alloy. An intermediate alloy of Cr may be an Al-Cr intermediate alloy.

For example, a process of preparing the alloy melt is as follows: After a surface of an aluminum ingot raw material of recycled aluminum is cleaned, the aluminum ingot is placed in a crucible for heating and melting, and a temperature of the molten aluminum is controlled to be 710°C to 730°C. When the temperature of the molten aluminum reaches 710°C to 730°C, the temperature of the molten aluminum is increased to 780°C to 800°C, and the intermediate alloys of various elements are dried, and then added to the molten aluminum. The molten aluminum is kept at this temperature for 10 to 20 minutes to ensure that all added intermediate alloys are completely and uniformly melted.

It may be understood that, in addition to first melting the pure aluminum ingot and then melting other compositions, the pure aluminum ingot and various compositions may be added together and then heated to obtain the alloy melt, provided that the raw materials weighed based on the compositions of the aluminum alloy can be mixed and melted. A sequence of adding the raw materials is not limited herein.

The process of refining, degassing, and drossing is as follows: When the temperature of the alloy melt is decreased to 730°C to 750°C, a sodium-free refining agent of the aluminum alloy starts to be pressed into the molten aluminum by using a rotary degassing machine for refining. Preset refining time is, for example, 10 to 30 minutes. Then, drossing is performed, and the alloy melt is kept still. The alloy melt is kept still for 0.5 to 1.5 hours. After the alloy melt is kept still, hydrogen content of the alloy melt is measured by using a hydrogen gauge. When the hydrogen content is less than 0.3 ml/100g, for example, less than or equal to 0.2 ml/100g, die casting is performed.

For example, in the process of refining, degassing, and drossing, a refining agent is first added to the alloy melt, and a rotary degasser is used to refine and degas the alloy melt to which the refining agent is added. After refining and degassing are performed for preset duration, drossing is performed, and then the alloy melt is kept still for a period of time. Then, after the alloy melt is kept still, the hydrogen content in the alloy melt is measured by using the hydrogen gauge, and it is determined whether the hydrogen content is greater than a threshold. If the hydrogen content is greater than the threshold, it indicates that the hydrogen content in the alloy melt is still high, and drossing and degassing processing further needs to be performed. Therefore, the foregoing drossing and degassing process continues to be performed. If the hydrogen content is not greater than the threshold, it indicates that the hydrogen content in the alloy melt already meets a requirement. In this case, it may be determined that drossing and degassing end, and the die casting molding process may be performed. The threshold may be designed based on factors such as impact of hydrogen content on the aluminum alloy casting part and a performance requirement for the aluminum alloy casting part. This is not limited herein. By way of example rather than limitation, the threshold is set to be not greater than 0.3 ml/100g. Further, the threshold may be optimized to 0.2 ml/100g, and the hydrogen content in the alloy melt is less than or equal to 0.2 ml/100g. In addition, a type of the refining agent may be selected based on an actual situation, for example, but not limited to a sodium-free refining agent. This is not limited herein. It should be understood that, when the alloy melt is prepared, a solubility of hydrogen in the alloy melt is high at a high temperature, so that hydrogen is very easily dissolved in the molten aluminum. In the die casting molding process, a temperature of the alloy melt decreases, hydrogen is gradually precipitated due to a decrease in the solubility of the hydrogen. If degassing is not performed before die casting molding, defects such as air holes and pinholes are generated in the aluminum alloy casting part, and these defects may cause bubbles on the surface of the casting part when the aluminum alloy casting part is brazed at a high temperature. Therefore, after drossing and degassing, bubbles of the aluminum alloy casting part can be reduced after the aluminum alloy casting part is brazed at a high temperature. In this way, a height of a bubble after the aluminum alloy casting part is brazed at a high temperature does not exceed 0.5 mm. The threshold is further optimized, and the height of the bubble after the aluminum alloy casting part is brazed at a high temperature can be further reduced to less than 0.2 mm or there may be no bubble.

Die casting molding: The molten aluminum on which degassing is performed is placed in a molding cavity, and vacuum die casting molding is performed on the molten aluminum. A vacuum degree of the molding cavity is less than or equal to 100 mbar, for example, less than or equal to 50 mbar or 30 mbar. The vacuum degree is optimized, so that a die casting effect during vacuum die casting molding can be improved, gas contained in the aluminum alloy casting part can be reduced, and mechanical properties of the aluminum alloy casting part are further improved. In addition, the vacuum degree is optimized, bubbles of the aluminum alloy casting part obtained through die casting molding can be reduced after being brazed at a high temperature and fluidity of the alloy melt can be further reduced.

In the preparation method in this embodiment of this application, after degassing and high-vacuum-degree die casting are performed on the alloy melt, gas content of the die casting part is low, and a bubble amount can be reduced after being brazed at a high temperature, or there may further be no bubble. After the test, heights of bubbles on surfaces of die casting parts after being brazed are less than or equal to 0.5 mm, heights of bubbles on some die casting parts are less than or equal to 0.2 mm, and there is even no bubble on surfaces of some die casting parts.

Based on a same inventive objective, an embodiment of this application further provides a die casting part. The die casting part may be prepared by using the aluminum alloy in embodiments of this application. The die casting part in this embodiment of this application may be used for heat dissipation.

For example, the die casting part in this embodiment of this application may be mainly used in the wireless communication field, for example, a multiple-input multiple-output (massive input massive output, MIMO) unit and an RRU, and a liquid cooling heat dissipation box. The die casting part in this embodiment of this application may be further used in a component in the in-vehicle heat dissipation field, for example, a modular powertrain (modular drivetrain concept, MDC) device. The aluminum alloy in this application may be used to prepare components such as a heat dissipation panel and a heat sink of the foregoing device.

Based on a same inventive objective, an embodiment of this application further provides a welding component. The welding component includes a metallic matrix and the die casting part in embodiments of this application. The die casting part may be welded to the metallic matrix, for example, through tunnel furnace atmosphere protection brazing or vacuum furnace brazing. The metallic matrix may be prepared by using the aluminum alloy in embodiments of this application, or may be prepared by using a weldable aluminum alloy with other compositions.

Based on a same inventive objective, an embodiment of this application further provides an electronic device. The electronic device may include a processing unit and a package part. At least a part of structural parts in the package part may be obtained through die casting molding by using the aluminum alloy in embodiments of this application.

The following further describes in detail the aluminum alloy in this application with reference to embodiments.

### Embodiment 1

The aluminum alloy in this embodiment is a die casting part, and compositions of the aluminum alloy of the die casting part are Al-3.17La-5.86Ce-1.3Fe-0.54Mn-0.23Zr-0.22Cr. La accounts for 3.17% of a total mass of the aluminum alloy. Ce accounts for 5.86% of the total mass of the aluminum alloy. Fe accounts for 1.3% of the total mass of the aluminum alloy. Mn accounts for 0.54% of the total mass of the aluminum alloy. Cr accounts for 0.12% of the total mass of the aluminum alloy. Zr accounts for 0.17% of the total mass of the aluminum alloy. Except Al, other elements are inevitable impurities. Content of the inevitable impurities is listed in Table 2.

### Embodiment 2

Compositions of the aluminum alloy in this embodiment are Al-2.96La-5.88Ce-1.2Fe-0.85Mn-0.25Zr-0.03Cr.

### Embodiment 3

Compositions of the aluminum alloy in this embodiment are Al-3.15La-5.85Ce-0.7Fe-0.54Mn-0.23Zr-0.23Cr.

### Embodiment 4

Compositions of the aluminum alloy in this embodiment are Al-3.14La-5.83Ce-1.3Fe-0.3Mn-0.23Zr-0.22Cr.

### Embodiment 5

Compositions of the aluminum alloy in this embodiment are Al-3.18La-5.82Ce-1.3Fe-0.56Mn-0.1Zr-0.22Cr.

### Embodiment 6

Compositions of the aluminum alloy in this embodiment are Al-3.16La-5.85Ce-1.3Fe-0.57Mn-0.23Zr-0.6Cr.

Compositions of the aluminum alloy in Embodiment 1 to Embodiment 6 are listed in Table 1.

### Comparative examples 1 to 3

The comparative examples 1 to 3 each are an aluminum alloy, and compositions of the aluminum alloy are listed in Table 3.

**Table 2**

| | Lanthanum | Cerium | Iron | Manganese | Zirconium | Chromium | Silicon |
|---|---|---|---|---|---|---|---|
| Embodiment 1 | 3.17% | 5.86% | 1.3% | 0.54% | 0.23% | 0.22% | 0.0388% |
| Embodiment 2 | 2.96% | 5.88% | 1.2% | 0.85% | 0.25% | 0.03% | 0.0229% |
| Embodiment 3 | 3.15% | 5.85% | 0.7% | 0.54% | 0.23% | 0.23% | 0.0325% |
| Embodiment 4 | 3.14% | 5.83% | 1.3% | 0.3% | 0.23% | 0.22% | 0.0278% |
| Embodiment 5 | 3.18% | 5.82% | 1.3% | 0.56% | 0.10% | 0.22% | 0.0242% |
| Embodiment 6 | 3.16% | 5.85% | 1.3% | 0.57% | 0.23% | 0.60% | 0.0313% |

**Table 3**

| Sequence number | Silicon | Copper | Iron | Manganese | Nickel | Chromium |
|---|---|---|---|---|---|---|
| Comparative example 1 | 10% | 2.5% | 1.3% | - | - | - |
| Comparative example 2 | - | - | 0.6% | 1.6% | - | - |
| Comparative example 3 | - | - | 1.2% | 1.2% | 3% | 0.4% |

| | | | | | | |
|---|---|---|---|---|---|---|
| Note: In Table 3, "-" indicates that there is no such an element or the element exists as an inevitable impurity element. | | | | | | |

A melting point, yield strength after being brazed, tensile strength after being brazed, and a thermal conductivity coefficient of each of the aluminum alloys in the embodiments and the comparative examples are separately tested. Test results are listed in Table 4. A process condition of high-temperature brazing is as follows: Tunnel furnace atmosphere protection brazing is used, a welding temperature is 600°C (optional temperature: 590°C/600°C/610°C/620°C/630°C), and a brazing metal is a 4343 brazing metal (optional brazing metal: 4045/4047).

A specific test process of each parameter is as follows:
Melting point test: Perform a differential scanning calorimetry (differential scanning calorimetry, DSC) test on a cut aluminum alloy casting part sample to obtain a melting point.

Mechanical property test: Cut standard tensile mechanical test pieces from the aluminum alloys in the embodiments and the comparative examples based on requirements of GB/T 228, and test mechanical properties on a tensile test machine.

Thermal conductivity test: Perform testing by using a laser flash method (ASTM E 1561-01). A sample dimension is Φ12.7 mm × 3 mm. For specific heat, refer to ISO11357 and ASTM E1269. For density, refer to ISO 1183-1:2004.

**Table 4**

| Sequence number | Melting point | Yield strength obtained through brazing | Tensile strength obtained through brazing | Thermal conductivity coefficient |
|---|---|---|---|---|
| | °C | MPa | MPa | W/m·K |
| Embodiment 1 | 640 | 122 | 162 | 151 |
| Embodiment 2 | 642 | 122 | 161 | 155 |
| Embodiment 3 | 639 | 110 | 158 | 158 |
| Embodiment 4 | 642 | 105 | 155 | 160 |
| Embodiment 5 | 641 | 108 | 157 | 155 |
| Embodiment 6 | 642 | 115 | 156 | 135 |
| Comparative example 1 | 516 | Molten | Molten | 96 |
| Comparative example 2 | 650 | 45 | 150 | 150 |
| Comparative example 3 | 641 | 55 | 170 | 115 |

It can be learned from related data in Table 4 that, in the aluminum alloys in Embodiments 1 to 6, because the melting points of the aluminum alloys in embodiments of this application are all higher than 620°C, a base material of the aluminum alloy in embodiments of this application does not melt in a brazing process. For the aluminum alloy in the comparative example 1, a melting point temperature of the aluminum alloy is low, and brazing cannot be implemented. Melting occurs after brazing. The aluminum alloy in the comparative example 2 and the aluminum alloy in the comparative example 3 have high melting points. However, after the aluminum alloy is brazed, yield strength is excessively low and is lower than 60 MPa. In a mounting process, for example, during threaded connection, a thread slipping problem is likely to occur.

It can be learned from comparison data in Embodiment 1 and Embodiment 3 that, when the content of Fe is within a range of 1.1% to 1.3%, the aluminum alloy die casting part can obtain higher yield strength. It can be learned from comparison data in Embodiment 1, Embodiment 4, and Embodiment 6 that, when the aluminum alloy contains Cr, the content of Cr is within a range of 0.1% to 0.25%, and the content of Mn is within a range of 0.5% to 0.60%, the mechanical properties of the aluminum alloy die casting part can be improved. It can be learned from comparison data in Embodiment 1 and Embodiment 5 that, when the content of Zr of the aluminum alloy is within a range of 0.2% to 0.35%, the mechanical properties of the aluminum alloy die casting part can be improved.

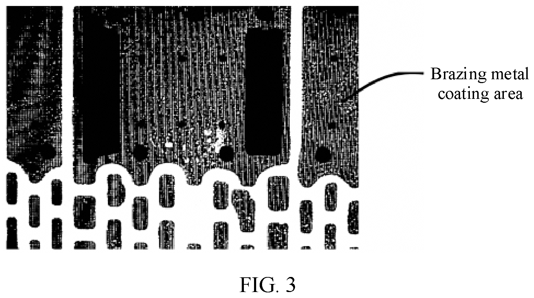

After the aluminum alloy die casting part in Embodiment 1 is brazed at a high temperature, brazed rate detection of a combined weldment is tested. FIG. 3 is an ultrasonic detection diagram of a surface of a die casting part after being brazed. As shown in FIG. 3, a gray area is a brazing metal coating area. A brazed rate of the brazing metal may be greater than 90%, so that two aluminum alloy die casting parts can be better welded together, to improve welding strength. Therefore, the aluminum alloy die casting part provided in this embodiment of this application is applicable to high-temperature brazing, and has good welding strength after high-temperature brazing, so that strength of a structure after welding can be improved. In addition, there is no bubble on the surface of the aluminum alloy die casting part in this embodiment of this application after being brazed.

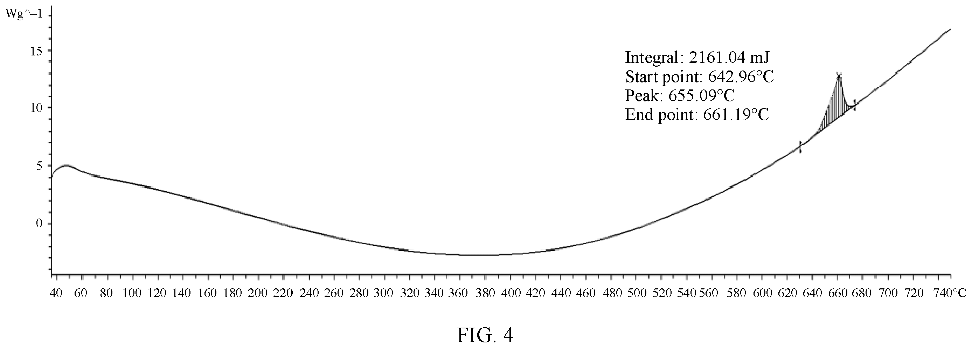

FIG. 4 is a diagram of a DSC test curve of an aluminum alloy according to Embodiment 1. As shown in FIG. 4, an endothermic peak of the aluminum alloy in Embodiment 1 is about 640°C. It should be noted that, it is clear that the melting point of the aluminum alloy in this embodiment of this application is higher than the brazing temperature.

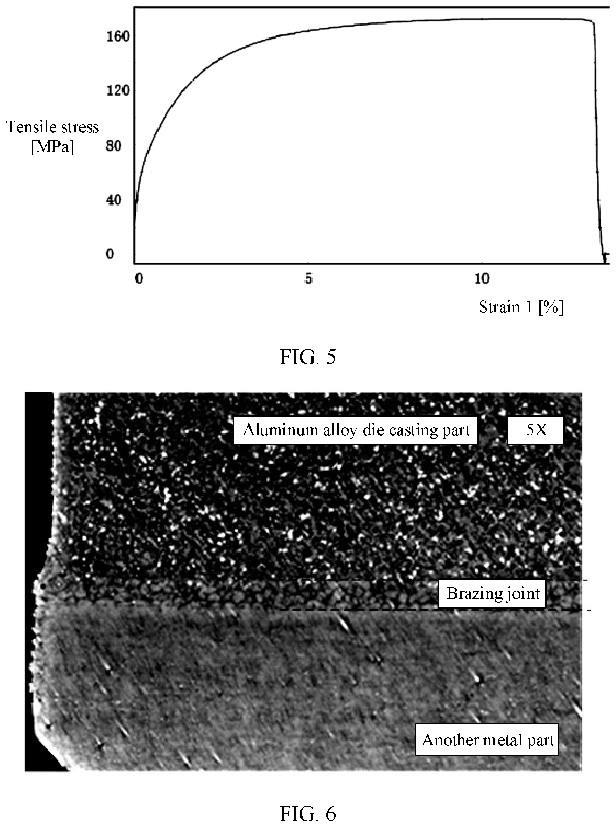

FIG. 5 is a stress and strain curve of an aluminum alloy according to Embodiment 1 after being brazed. As shown in FIG. 5, yield strength of the aluminum alloy in Embodiment 1 of this application after being brazed may be higher than 120 MPa.

FIG. 6 is a diagram of a welding joint after an aluminum alloy according to Embodiment 1 is brazed with another metal part. As shown in FIG. 6, a component at an upper part of the figure is the aluminum alloy, and a component at a lower part of the figure is the another metal plate. After the two components are brazed, no welding hole is generated at the welding joint.

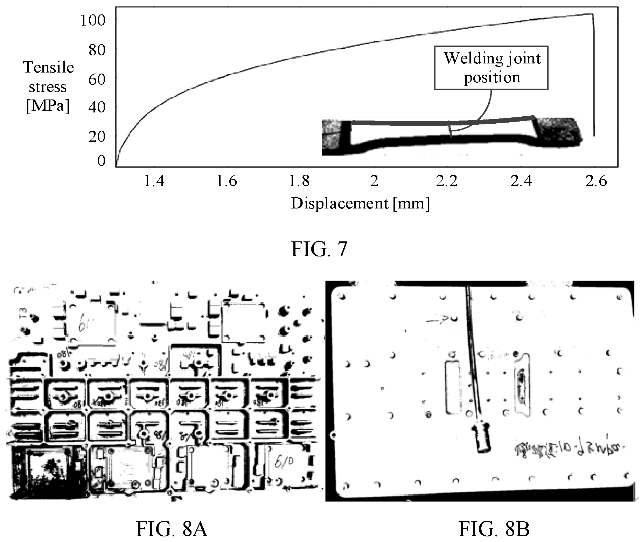

FIG. 7 is a stress and strain curve at a welding joint of an aluminum alloy according to Embodiment 1. The two aluminum alloys in Embodiment 1 are welded to form symmetrical tensile test strips, and a width of each of the test strips is 10 mm. A welding joint is located in the middle of the two aluminum alloys. As shown in FIG. 7, tensile strength of the welding joint may be higher than 100 MPa.

FIG. 8A and FIG. 8B are a diagram of a blasting structure after a die casting structural part and a plate are brazed according to an embodiment. As shown in FIG. 8A and FIG. 8B, the die casting structural part in FIG. 8A is formed through die casting by using the aluminum alloy in this application. A structure of the die casting structural part is complex, and the die casting structural part can be formed through die casting molding at one time. The plate in FIG. 8B may be a 3003 plate. After the die casting structural part is welded to the plate, blasting separation is performed, and blasting pressure is 11 MPa. As shown in FIG. 8A and FIG. 8B, high blasting pressure may also indicate that a high-strength sealed connection structure may be formed between the die casting structural part and the plate in this application, and can meet a requirement of high-pressure brazed sealing.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An aluminum alloy, wherein based on a total weight of the aluminum alloy, the aluminum alloy comprises the following elements in weight percentage: 0.01% to 15% of La, 0.01% to 15% of Ce, 0.3% to 3% of Fe, 0.3% to 3% of Mn, and 0.01% to 0.5% of Zr, a sum of content of La and Ce is 3% to 15%, a remainder comprises Al and inevitable impurities, and content of any impurity element in the inevitable impurities is less than 0.2%.

2. The aluminum alloy according to claim 1, wherein in terms of weight percentage, content of the elements La, Ce, Fe, Mn, and Zr in the aluminum alloy is as follows: 2% to 7% of La, 5% to 8% of Ce, 1.0% to 1.5% of Fe, 0.6% to 1% of Mn, and 0.2% to 0.5% of Zr.

3. The aluminum alloy according to claim 1, wherein in terms of weight percentage, the aluminum alloy further comprises 0.01% to 0.5% of Cr.

4. The aluminum alloy according to claim 3, wherein in terms of weight percentage, content of the elements La, Ce, Fe, Mn, Zr, and Cr in the aluminum alloy is as follows: 2% to 7% of La, 5% to 8% of Ce, 1.0% to 1.5% of Fe, 0.45% to 0.6% of Mn, 0.2% to 0.5% of Zr, and 0.1% to 0.4% of Cr.

5. The aluminum alloy according to any one of claims 1 to 4, wherein in terms of weight percentage, the aluminum alloy further comprises at least one of the following elements: 0.01% to 0.5% of Sc, 0.01% to 0.5% of V, 0.01% to 0.5% of Mo, 0.01% to 0.5% of Mg, and 0.01% to 0.5% of Ti.

6. The aluminum alloy according to any one of claims 1 to 5, wherein a melting point of the aluminum alloy is greater than or equal to 620°C.

7. The aluminum alloy according to any one of claims 1 to 6, wherein a thermal conductivity coefficient of the aluminum alloy is greater than or equal to 120 W/m·K.

8. The aluminum alloy according to any one of claims 1 to 7, wherein yield strength of the aluminum alloy after being brazed at 590°C to 630°C is greater than or equal to 80 MPa.

9. An aluminum alloy preparation method, comprising: melting, based on compositions of the aluminum alloy according to any one of claims 1 to 8, intermediate alloys of various elements to obtain an alloy melt, and performing die casting molding on the alloy melt after refining, degassing, and drossing, to obtain the aluminum alloy.

10. A die casting part, prepared by using the aluminum alloy according to any one of claims 1 to 8.

11. A welding component, comprising a metallic matrix and the die casting part according to claim 10, wherein the die casting part is connected to the metallic matrix through brazing.

12. An electronic device, comprising a processing unit and a package part configured to package the processing unit, wherein at least a part of structural parts in the package part are formed by using the aluminum alloy according to any one of claims 1 to 8 through die casting.
